(19) Europäisches Patentamt
European Patent Office
Office européen des brevets

(11) **EP 4 542 314 A1**

(12) **EUROPÄISCHE PATENTANMELDUNG**

(43) Veröffentlichungstag:
**23.04.2025 Patentblatt 2025/17**

(21) Anmeldenummer: **23204535.1**

(22) Anmeldetag: **19.10.2023**

(51) Internationale Patentklassifikation (IPC):
**G05B 17/02** (2006.01)  **G05B 19/418** (2006.01)
**B60W 50/00** (2006.01)

(52) Gemeinsame Patentklassifikation (CPC):
**G05B 17/02; G05B 19/41885**

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**KH MA MD TN**

(71) Anmelder: **Robert Bosch GmbH**
**70442 Stuttgart (DE)**

(72) Erfinder: **Steeb, Maximilian**
**71384 Weinstadt (DE)**

(54) **VERFAHREN ZUM VALIDIEREN EINES ENTWURFSMODELLS FÜR EIN TECHNISCHES SYSTEM**

(57)     Die Erfindung betrifft ein Verfahren (100) zum Validieren eines Entwurfsmodells (2) für ein technisches System (1), umfassend die nachfolgenden Schritte:
- Bereitstellen (101) des Entwurfsmodells (2), wobei das Entwurfsmodell (2) das technische System (1) modelliert, wobei das Entwurfsmodell (2) einen zulässigen Bereich für wenigstens einen Parameter des technischen Systems (1) und für wenigstens eine Störgröße angibt,
- Initiieren (102) einer Anwendung eines Prüfsignals auf das technische System (1),
- Initiieren (103) einer Erfassung einer durch das Prüfsignal ausgelösten Ausgabe des technischen Systems (1),
- Ermitteln (104) eines Zustands des technischen Systems (1) auf Basis des Prüfsignals und der erfassten Ausgabe, wobei auf Basis des Zustands ein jeweiliger Wert für den wenigstens einen Parameter des technischen Systems (1) bestimmt wird,
- Ermitteln (105) einer Störung in dem technischen System (1) auf Basis des Prüfsignals, der erfassten Ausgabe und dem ermittelten Zustand, wobei ein jeweiliger Wert für die wenigstens eine Störgröße bestimmt wird,
- Validieren (106) des Entwurfsmodells (2) für das technische System (1), wobei der jeweilige Wert für den wenigstens einen Parameter des technischen Systems (1) und der jeweilige Wert für die wenigstens eine Störgröße mit dem zulässigen Bereich des Entwurfsmodells (2) verglichen werden.
    Ferner betrifft die Erfindung ein Computerprogramm, eine Vorrichtung sowie ein Speichermedium zu diesem Zweck.

Fig. 1

EP 4 542 314 A1

**Beschreibung**

Die Erfindung betrifft ein Verfahren zum Validieren eines Entwurfsmodells für ein technisches System. Ferner betrifft die Erfindung ein Computerprogramm, eine Vorrichtung sowie ein Speichermedium zu diesem Zweck.

Stand der Technik

Der modellbasierte Reglerentwurf für ein technisches System stützt sich insbesondere auf Entwurfsmodelle, welche in der Entwicklungsphase zur Modellierung des zu regelnden technischen Systems verwendet wurden. Insbesondere bei dem Versuch, Stabilitäts- und Sicherheitsgarantien zu geben, können Unsicherheiten und Störungen innerhalb des Entwurfsmodells berücksichtigt werden, die als Sätze von Parametern beschrieben werden können, welche wiederum auf Mengen basieren oder stochastisch sein können. In der Entwurfsphase wird das technische System insbesondere unter Verwendung des Entwurfsmodells mit dem angenommenen Satz von Parametern so entworfen, dass Stabilitäts- und Sicherheitsgarantien unter Berücksichtigung der Unsicherheiten und Störungen gegeben werden können.

Für eine Parameteridentifikation von technischen Systemen im Allgemeinen, insbesondere von Regelsystemen, gibt es verschiedene Algorithmen, die nominale Parameterwerte schätzen, oder die Unsicherheitsquantifizierung, die die Parameterverteilungen unsicherer Parameter schätzen kann.

In der realen Anwendung des technischen Systems können die Stabilitäts- und Sicherheitsgarantien allerdings nur so lange gelten, wie die Annahmen bezüglich der Parameter des Entwurfsmodells dem Verhalten unter realen Bedingungen entsprechen.

Offenbarung der Erfindung

Gegenstand der Erfindung ist ein Verfahren mit den Merkmalen des Anspruchs 1, ein Computerprogramm mit den Merkmalen des Anspruchs 8, eine Vorrichtung mit den Merkmalen des Anspruchs 9 sowie ein computerlesbares Speichermedium mit den Merkmalen des Anspruchs 10. Weitere Merkmale und Details der Erfindung ergeben sich aus den jeweiligen Unteransprüchen, der Beschreibung und den Zeichnungen. Dabei gelten Merkmale und Details, die im Zusammenhang mit dem erfindungsgemäßen Verfahren beschrieben sind, selbstverständlich auch im Zusammenhang mit dem erfindungsgemäßen Computerprogramm, der erfindungsgemäßen Vorrichtung sowie dem erfindungsgemäßen computerlesbaren Speichermedium, und jeweils umgekehrt, so dass bezüglich der Offenbarung zu den einzelnen Erfindungsaspekten stets wechselseitig Bezug genommen wird bzw. werden kann.

Gegenstand der Erfindung ist insbesondere ein Verfahren zum Validieren eines Entwurfsmodells für ein technisches System, umfassend die nachfolgenden Schritte, wobei die Schritte wiederholt und/oder nacheinander durchgeführt werden können. Das technische System umfasst insbesondere wenigstens einen Regelkreis. Das technische System kann auch ein Regelungssystem sein.

In einem ersten Schritt wird bevorzugt das Entwurfsmodells bereitgestellt, wobei das Entwurfsmodell das technische System modelliert. Das Entwurfsmodell gibt insbesondere einen zulässigen Bereich für wenigstens einen Parameter des technischen Systems und für wenigstens eine Störgröße an. Der zulässige Bereich kann beispielsweise jeweils ein Minimal- und Maximalwert oder eine stochastische Verteilung für den wenigstens einen Parameter oder die wenigstens eine Störgröße sein. Der wenigstens eine Parameter kann beispielsweise eine Fahrzeugmasse und die wenigstens eine Störgröße beispielsweise eine Stör-Kraft sein. Der zulässige Bereich kann auch als eine Annahme für den wenigstens einen Parameter oder die wenigstens eine Störgröße verstanden werden und beispielsweise auf Erfahrungswerten basieren oder durch Tests ermittelt werden.

In einem weiteren Schritt wird vorzugsweise eine Anwendung eines Prüfsignals auf das technische System initiiert. Das Prüfsignal kann beispielsweise ein Wert für eine Stellgröße in dem technischen System oder in einem Regelkreis des technischen Systems sein.

In einem weiteren Schritt wird vorzugsweise eine Erfassung einer durch das Prüfsignal ausgelösten Ausgabe des technischen Systems initiiert. Die Ausgabe kann beispielsweise eine Stellgröße in dem technischen System oder in einem Regelkreis des technischen Systems oder ein Messwert eines Sensors des technischen Systems sein.

In einem weiteren Schritt wird vorzugsweise ein Zustand des technischen Systems auf Basis des Prüfsignals und der erfassten Ausgabe ermittelt, wobei auf Basis des Zustands ein jeweiliger Wert für den wenigstens einen Parameter des technischen Systems bestimmt wird. Der Zustand kann als ein Zustandsvektor vorliegen, welcher auf aktuellen Werten des wenigstens einen Parameters, insbesondere einer Vielzahl an Parametern basiert oder diese umfasst.

In einem weiteren Schritt wird vorzugsweise eine Störung in dem technischen System auf Basis des Prüfsignals, der erfassten Ausgabe und dem ermittelten Zustand ermittelt, wobei ein jeweiliger Wert für die wenigstens eine Störgröße bestimmt wird. Die Störung kann somit eine Gesamtheit der wenigstens einen Störgröße sein, wobei eine Vielzahl an Störgrößen vorliegen können. Eine Störgröße kann beispielsweise ein ungesteuerter Einfluss wie ein Fahrtwind oder eine Reibung oder eine Erwärmung sein.

In einem weiteren Schritt wird vorzugsweise das Entwurfsmodell für das technische System validiert, wobei der jeweilige Wert für den wenigstens einen Parameter des technischen Systems und der jeweilige Wert für die wenigstens eine Störgröße mit dem zulässigen Bereich des Entwurfsmodells verglichen werden. So kann vorteilhaft einerseits festgestellt werden, ob das Entwurfsmodell das technische System unter realen Bedingungen korrekt modelliert und andererseits, ob ein Fehler in dem technischen System vorliegt.

Von weiterem Vorteil kann vorgesehen sein, dass das Verfahren ferner den folgenden Schritt umfasst:

- Übertragen der erfassten Ausgabe des technischen Systems an eine externe Datenverarbeitungsvorrichtung.

Die externe Datenverarbeitungsvorrichtung kann beispielsweise ein Server sein und drahtlos oder drahtgebunden mit dem technischen System verbunden sein, um eine bidirektionale Kommunikation bereitzustellen. Das Ermitteln des Zustands und das Ermitteln der Störung und das Validieren des Entwurfsmodells können zusätzlich oder alternativ auch vollständig durch die externe Datenverarbeitungsvorrichtung durchgeführt werden. So kann vorteilhaft ein Rechenaufwand zumindest teilweise ausgelagert werden. Ferner können so vorteilhaft an einer zentralen externen Datenverarbeitungsvorrichtung mehrere Ausgaben von einzelnen technischen Systemen analysiert werden, wodurch beispielsweise das Entwurfsmodell auf Basis der Ausgaben der mehreren technischen Systeme optimiert werden kann.

Des Weiteren ist es denkbar, dass das technische System ein Fahrzeug ist. Das Anwenden des Prüfsignals kann entsprechend durch wenigstens einen Aktor des Fahrzeugs und das Erfassen der durch das Prüfsignal ausgelösten Ausgabe durch wenigstens einen Sensor des Fahrzeugs durchgeführt werden. Es ist somit möglich, dass das erfindungsgemäße Verfahren bei einem Fahrzeug zum Einsatz kommt. Das Fahrzeug kann bspw. als ein Kraftfahrzeug und/oder Personenkraftfahrzeug und/oder autonomes Fahrzeug ausgebildet sein. Das Fahrzeug kann eine Fahrzeugeinrichtung, bspw. zur Bereitstellung einer autonomen Fahrfunktion und/oder ein Fahrerassistenzsystem aufweisen. Die Fahrzeugeinrichtung kann dazu ausgeführt sein, das Fahrzeug zumindest teilweise automatisch zu steuern und/oder zu beschleunigen und/oder abzubremsen und/oder zu lenken.

Vorteilhafterweise kann im Rahmen der Erfindung vorgesehen sein, dass das Verfahren ferner den folgenden Schritt umfasst:

- Durchführen wenigstens einer Maßnahme auf Basis eines Ergebnisses des Validierens, wobei die wenigstens eine Maßnahme das technische System und/oder das Entwurfsmodell beeinflusst.

So kann vorteilhaft neben dem Validieren auch ein entsprechendes Reagieren sowohl im Hinblick auf das technische System als auch im Hinblick auf das Entwurfsmodell auf Basis des Ergebnisses des Validierens bereitgestellt werden.

Ein weiterer Vorteil kann im Rahmen der Erfindung erzielt werden, wenn das Durchführen der wenigstens einen Maßnahme den folgenden Schritt umfasst:

- Anpassen wenigstens einer Funktion des technischen Systems, um durch das Anpassen eine Sicherheit des technischen Systems zu erhöhen.

Das Anpassen kann beispielsweise ein Degradieren oder ein Deaktivieren der Funktion des technischen Systems sein. Es ist denkbar, dass das Degradieren oder Deaktivieren der Funktion für eine definierte Zeitspanne erfolgt. Im Falle eines Fahrzeugs als technisches System kann beispielsweise im Rahmen des Validierens festgestellt werden, dass eine hohe Störung, d.h. ein Wert für wenigstens eine Störgröße außerhalb des zulässigen Bereichs des Entwurfsmodells, vorliegt, sodass das Fahrzeug durch das Anpassen der wenigstens einen Funktion nicht gefahren werden kann, solange die Störung, d.h. insbesondere der Wert für die wenigstens eine Störgröße, außerhalb des zulässigen Bereichs des Entwurfsmodells ist. Ferner ist im Falle eines Fahrzeugs möglich, dass das Anpassen der wenigstens einen Funktion ein Anpassen einer geplanten Trajektorie des Fahrzeugs umfasst. So kann beispielsweise auf Basis der Ausgabe des technischen Systems festgestellt werden, dass das Entwurfsmodell nicht exakt die Realität abgebildet hat, sodass die geplante Trajektorie vorteilhaft unter Berücksichtigung der Ausgabe präzise angepasst werden kann.

Es kann von Vorteil sein, wenn im Rahmen der Erfindung das Durchführen der wenigstens einen Maßnahme den folgenden Schritt umfasst:

- Anpassen des Entwurfsmodells auf Basis des Ergebnisses des Validierens, um durch das Anpassen das Entwurfsmodell für das technische System zu individualisieren.

Dadurch kann das Entwurfsmodell vorteilhaft iterativ an ein Verhalten des technischen Systems unter realen Bedingungen angepasst und optimiert werden.

Beispielsweise kann es vorgesehen sein, dass das Entwurfsmodell als eine Referenz zur Überwachung des technischen Systems verwendet und auf Basis einer Modellierung des technischen Systems ermittelt wird. Das Entwurfsmodell kann das technische System zumindest auf Basis von Gleichungen und Annahmen für den wenigstens einen Parameter und die wenigstens eine Störgröße beschreiben. Ferner kann der Zustand zumindest einen physikalischen Energiespeicher des technischen Systems und die Störung zumindest einen Umwelteinfluss auf das technische System repräsentieren. Der Zustand kann für das Beispiel eines Fahrzeugs als technisches System beispielsweise eine Geschwindigkeit des Fahrzeugs und die Störung ein Fahrtwind sein.

Ebenfalls Gegenstand der Erfindung ist ein Computerprogramm, insbesondere Computerprogrammprodukt, umfassend Befehle, die bei der Ausführung des Computerprogrammes durch einen Computer diesen veranlassen, das erfindungsgemäße Verfahren auszuführen. Damit bringt das erfindungsgemäße Computerprogramm die gleichen Vorteile mit sich, wie sie ausführlich mit Bezug auf ein erfindungsgemäßes Verfahren beschrieben worden sind.

Ebenfalls Gegenstand der Erfindung ist eine Vorrichtung zur Datenverarbeitung, die eingerichtet ist, das erfindungsgemäße Verfahren auszuführen. Als die Vorrichtung kann bspw. ein Computer vorgesehen sein, welcher das erfindungsgemäße Computerprogramm ausführt. Der Computer kann wenigstens einen Prozessor zur Ausführung des Computerprogramms aufweisen. Auch kann ein nicht-flüchtiger Datenspeicher vorgesehen sein, in welchem das Computerprogramm hinterlegt und von welchem das Computerprogramm durch den Prozessor zur Ausführung ausgelesen werden kann.

Ebenfalls Gegenstand der Erfindung kann ein computerlesbares Speichermedium sein, welches das erfindungsgemäße Computerprogramm aufweist und/oder Befehle umfasst, die bei der Ausführung durch einen Computer diesen veranlassen, das erfindungsgemäße Verfahren auszuführen. Das Speichermedium ist bspw. als ein Datenspeicher wie eine Festplatte und/oder ein nicht-flüchtiger Speicher und/oder eine Speicherkarte ausgebildet. Das Speichermedium kann z. B. in den Computer integriert sein.

Darüber hinaus kann das erfindungsgemäße Verfahren auch als ein computerimplementiertes Verfahren ausgeführt sein.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Es zeigen:

Fig. 1　eine schematische Visualisierung eines Verfahrens, einer Vorrichtung, eines Speichermediums sowie eines Computerprogramms gemäß Ausführungsbeispielen der Erfindung,

Fig. 2　eine schematische Darstellung eines technischen Systems, eines Aktors, eines Sensors und einer externen Datenverarbeitungsvorrichtung gemäß Ausführungsbeispielen der Erfindung,

Fig. 3　eine schematische Darstellung eines Verfahrens gemäß Ausführungsbeispielen der Erfindung.

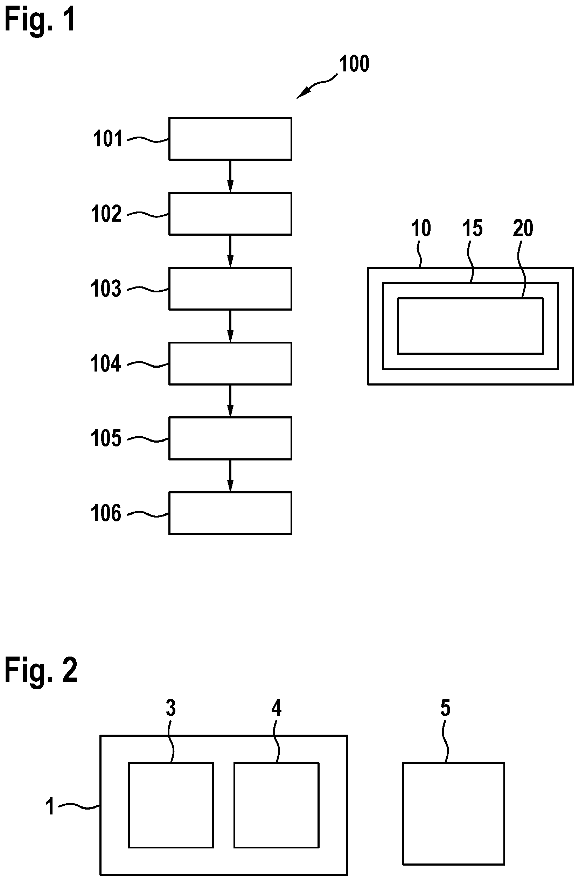

In Fig. 1 sind ein Verfahren 100, eine Vorrichtung 10, ein Speichermedium 15 sowie ein Computerprogramm 20 gemäß Ausführungsbeispielen der Erfindung schematisch dargestellt.

Fig. 1 zeigt insbesondere ein Ausführungsbeispiel für ein Verfahren 100 zum Validieren eines Entwurfsmodells 2 für ein technisches System 1, umfassend die nachfolgenden Schritte. In einem ersten Schritt 101 wird das Entwurfsmodell 2 bereitgestellt, wobei das Entwurfsmodell 2 das technische System 1 modelliert. Das Entwurfsmodell 2 gibt dabei einen zulässigen Bereich für wenigstens einen Parameter des technischen Systems 1 und für wenigstens eine Störgröße an. In einem zweiten Schritt 102 wird eine Anwendung eines Prüfsignals auf das technische System 1 initiiert. In einem dritten Schritt 103 wird eine Erfassung einer durch das Prüfsignal ausgelösten Ausgabe des technischen Systems 1 initiiert. In einem vierten Schritt 104 wird ein Zustand des technischen Systems 1 auf Basis des Prüfsignals und der erfassten Ausgabe ermittelt, wobei auf Basis des Zustands ein jeweiliger Wert für den wenigstens einen Parameter des technischen Systems 1 bestimmt wird. In einem fünften Schritt 105 wird eine Störung in dem technischen System 1 auf Basis des Prüfsignals, der erfassten Ausgabe und dem ermittelten Zustand ermittelt, wobei ein jeweiliger Wert für die wenigstens eine Störgröße bestimmt wird. In einem sechsten Schritt 106 wird das Entwurfsmodell 2 für das technische System 1 validiert, wobei der jeweilige Wert für den wenigstens einen Parameter des technischen Systems 1 und der jeweilige Wert für die wenigstens eine Störgröße mit dem zulässigen Bereich des Entwurfsmodells 2 verglichen werden.

In Fig. 2 sind ein technisches System 1, ein Aktor 3, ein Sensor 4 und eine externe Datenverarbeitungsvorrichtung 5 gemäß Ausführungsbeispielen der Erfindung schematisch dargestellt.

Ein Aspekt der vorliegenden Erfindung gemäß Ausführungsbeispielen ist insbesondere, dass ein Parameterschätzungsalgorithmus während einer Laufzeit des technischen Systems 1 verwendet wird, um die in der Entwicklungsphase getroffenen Annahmen des Entwurfsmodells 2 für das einzelne technische System 1 zu validieren.

Falls die Annahmen, d.h. insbesondere die zulässigen Bereiche, zu den Parametern während der Laufzeit verletzt werden, kann wenigstens eine Maßnahme durchgeführt werden, beispielsweise um einen Ausfall des technischen Systems 1 zu verhindern. Falls die Parameter noch innerhalb der zulässigen Bereiche liegen, aber anfangen zu driften (z. B. aufgrund von Alterung), kann das technische System 1 diese Information gemäß einer weiteren möglichen Maßnahme außerdem nutzen, um das Entwurfsmodell 2 zu optimieren. Die systemindividuellen Informationen über verletzte Annahmen könnten vorteilhaft auch für eine Vielzahl an technischen Systemen 1 aggregiert und an eine externe Datenverarbeitungsvorrichtung 5 und damit insbesondere an ein Entwicklungsteam weitergeleitet werden, um die Annahmen für die Parameter des Entwurfsmodells 2 zu verbessern, sodass die Leistung des technischen Systems 1 in künftigen Updates für die Vielzahl an technischen Systemen 1 durch Neueinstellung des Entwurfsmodells 2 verbessert werden kann.

Für den Fall eines autonom fahrenden Fahrzeugs als das technische System 1 könnte das Entwurfsmodell 2 an einen Trajektorien-Planer weitergeleitet, beziehungsweise für die Anpassung der Trajektorie des Fahrzeugs genutzt, werden. Dabei können die am besten passenden Eingangstrajektorien für das individuelle Fahrzeug ausgewählt werden, so dass die beste Leistung beziehungsweise eine hohe Sicherheit für das individuelle Fahrzeug gewährleistet werden kann. Die Parameterschätzung kann bereits an Prototypen des technischen Systems 1 durchgeführt werden, um mögliche Verletzungen der angenommenen Parameter zu erkennen, bevor das technische System 1 freigegeben wird. Im Falle von Verletzungen der Annahmen könnte beispielsweise eine Freigabe mit der aktuellen Steuerungssoftware abgebrochen werden. Die Information, welche Annahmen für die Parameter falsch waren, und die quantitativen Informationen könnten dann direkt zur Anpassung des Entwurfsmodells 2 verwendet werden.

Die Parameterschätzung kann während der Laufzeit auf dem technischen System 1 durchgeführt werden. Die ermittelten Werte für die Parameter werden vorzugsweise mit den Annahmen für die Parameter, d.h. insbesondere die zulässigen Bereiche, des Entwurfsmodells 2 aus der Entwurfsphase verglichen. Falls die ermittelten Werte außerhalb der zulässigen Bereiche der angenommenen Verteilungen der Parameter liegen, kann das technische System 1 beispielsweise durch die Maßnahme reagieren, dass wenigstens eine Funktion angepasst wird, also das technische System 1 beispielsweise in einen Degradationszustand übergeht oder sich abkoppelt und ein erneutes Einschalten verhindert.

Die ermittelten Parameter können gemäß eines Ausführungsbeispiels in eine Entwicklungs-Cloud hochgeladen werden, wo die Entwickler die Parameterverteilungen in einer Vielzahl an technischen Systemen 1 (z.B. eine Fahrzeugflotte) überwachen und so ihre Annahmen über die Verteilungen der Parameterwerte, d.h. insbesondere das Entwurfsmodell 2, verbessern können.

Das Entwurfsmodell 2 für das technische System 1 könnte auch online während der Laufzeit systemindividuell (z.B. fahrzeugindividuell) abgestimmt werden, um die Leistung im Hinblick auf die individuelle Systemrealisierung des technischen Systems 1 zu verbessern. Diese variiert beispielsweise auch über die Lebensdauer des technischen Systems 1.

Das Verfahren der Parametervalidierung, insbesondere der Validierung des Entwurfsmodells 2, gemäß einem Ausführungsbeispiel kann generell für alle Arten von technischen Systemen 1 verwendet werden, bei denen ein modellbasiertes Reglerentwurfsverfahren angewendet wurde.

Um das Verfahren gemäß einem möglichen Ausführungsbeispiel zu verdeutlichen, wird dieses im Folgenden für eine Querregelung hochautomatisierter Fahrzeuge (z.B. SAE-Level 4) beschrieben. Das Entwurfsmodell 2 für die Querregelung wird vorzugsweise aus einem linearisierten Einzelspurmodell abgeleitet. Der Zustandsvektor ist beispielsweise definiert als:

$$x = \left[\psi_e, \dot{\psi}_e, \beta, y_e, int(y_e), \delta, \dot{\delta}\right]^T$$

wobei insbesondere der Zustand $\psi_e$ eine Gierwinkelabweichung des Fahrzeugs, der Zustand $\dot{\psi}_e$ ein Gierratenfehler des Fahrzeugs, der Zustand $\beta$ der Schwimmwinkel, der Zustand $y_e$ ein lateraler Fehler, der Zustand $int(y_e)$ ein integrierter lateraler Seitenfehler und der Zustand $\delta$ ein Radlenkwinkel ist.

Für das sich ergebende technische System 1 in Form eines geschlossenen Regelsystems kann die Zustandsraumdarstellung in der folgenden Form dargestellt werden:

$$\dot{x} = A_c x + B_c u + E_c w$$

$$y = Cx$$

mit den Prüfsignalen in Form der Eingaben $u = [\dot{\psi}_d, \ddot{\psi}_d]^T$, wobei $\dot{\psi}_d$ eine gewünschte Gierrate und $\ddot{\psi}_d$ eine gewünschte Gierbeschleunigung ist, und der additiven Störung $w = [\Delta\delta, F_{dist}, M_{dist}]^T$, wobei die Störgröße $\Delta\delta$ ein Radlenkwinkelfehler, die Störgröße $F_{dist}$ eine laterale Störkraft und die Störgröße $M_{dist}$ ein Störmoment um die Hochachse des Fahrzeugs ist.

Die Systemmatrizen enthalten insbesondere eine Reihe von Parametern, die als Parametervektor $\Theta = [c_f, c_r, l_f, l_r, m, J_z, v_{veh}, ...]^T$ repräsentiert werden können. Im realen technischen System 1, insbesondere Fahrzeug, sind diese Parameter beispielsweise nicht konstant, sondern können innerhalb bestimmter Grenzen variieren, d.h. das technische System 1 kann parametrische Unsicherheiten aufweisen. Außerdem kann davon ausgegangen werden, dass die Eingaben $\dot{\psi}_d, \ddot{\psi}_d$ und die Störgrößen $\Delta\delta, F_{dist}, M_{dist}$, die auf das technische System 1 einwirken, ebenfalls innerhalb bestimmter Grenzen liegen. Während der Entwurfsphase können die Grenzen, d.h. insbesondere die zulässigen Bereiche, für die Parameter und Störgrößen beispielsweise durch eine Systemidentifikation und/oder durch Expertenschätzungen angenähert werden.

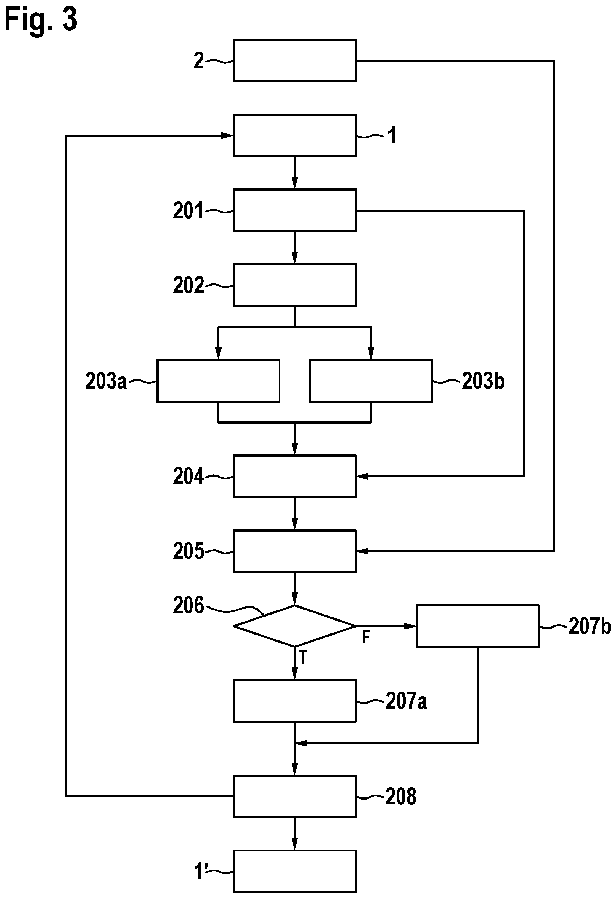

Fig. 3 zeigt eine schematische Darstellung eines Verfahrens gemäß eines Ausführungsbeispiels, die den Informationsfluss innerhalb eines technischen Systems 1, insbesondere eines Fahrzeugs, zeigt. Die folgenden Schritte werden vorzugsweise zyklisch angewendet. In einem ersten Schritt 201 wird hierbei ein Prüfsignal in Form eines Steuereingangs u an das technische System 1 in Form eines Regelungssystems gegeben. In einem zweiten Schritt 202 wird eine Reaktion y des technischen Systems 1 mit Hilfe von wenigstens einem Sensor 4, z.B. einer Ineratial Measurement Unit oder anderen Fahrzeugsensoren, gemessen. In einem dritten Schritt werden einerseits ein Zustand x des technischen Systems 1 203a und andererseits eine Störung w 203b geschätzt. In einem vierten Schritt 204 wird ein Parameteridentifikationsalgorithmus zur Schätzung des Parametervektors Θ^ ausgeführt. In einem fünften Schritt 205 wird ein Einzelvergleich zwischen den identifizierten Parametern und den für das Entwurfsmodell 2 angenommenen zulässigen Bereichen durchgeführt. In einem sechsten Schritt 206 wird geprüft, ob der Einzelvergleich aus Schritt 205 verletzte Annahmen der zulässigen Bereiche des Entwurfsmodells 2 ergeben hat. Wenn ja (Pfad "T" für true in Fig. 3) kann wenigstens eine Maßnahme durchgeführt werden und die ermittelten Werte der Parameter können beispielsweise in eine Entwicklungs-Cloud übertragen werden (Schritt 207a). Wenn nein (Pfad "F" für false in Fig. 3) kann eine Anpassung des Entwurfsmodells 2 durchgeführt werden. Ferner können im Falle eines Fahrzeugs als technisches System 1 aktualisierte Parameter bei der Trajektorienplanung verwendet werden, um fahrzeugspezifisch optimale Trajektorien für eine bessere Leistung und Sicherheit bereitzustellen (Schritt 207b). Auch in dieser Alternative können die ermittelten Parameter ferner in die Entwicklungs-Cloud übertragen werden. Somit werden als Ergebnis einerseits individuelle Maßnahmen und ein Feedback für das Entwurfsmodell 2 (Schritt 208) und andererseits ein in Bezug auf die Sicherheit und/oder Leistung optimiertes technisches System 1' erhalten.

Die voranstehende Erläuterung der Ausführungsformen beschreibt die vorliegende Erfindung ausschließlich im Rahmen von Beispielen. Selbstverständlich können einzelne Merkmale der Ausführungsformen, sofern technisch sinnvoll, frei miteinander kombiniert werden, ohne den Rahmen der vorliegenden Erfindung zu verlassen.

**Patentansprüche**

1. Verfahren (100) zum Validieren eines Entwurfsmodells (2) für ein technisches System (1), umfassend die nachfolgenden Schritte:

   - Bereitstellen (101) des Entwurfsmodells (2), wobei das Entwurfsmodell (2) das technische System (1) modelliert, wobei das Entwurfsmodell (2) einen zulässigen Bereich für wenigstens einen Parameter des technischen Systems (1) und für wenigstens eine Störgröße angibt,
   - Initiieren (102) einer Anwendung eines Prüfsignals auf das technische System (1),
   - Initiieren (103) einer Erfassung einer durch das Prüfsignal ausgelösten Ausgabe des technischen Systems (1),
   - Ermitteln (104) eines Zustands des technischen Systems (1) auf Basis des Prüfsignals und der erfassten Ausgabe, wobei auf Basis des Zustands ein jeweiliger Wert für den wenigstens einen Parameter des technischen Systems (1) bestimmt wird,
   - Ermitteln (105) einer Störung in dem technischen System (1) auf Basis des Prüfsignals, der erfassten Ausgabe und dem ermittelten Zustand, wobei ein jeweiliger Wert für die wenigstens eine Störgröße bestimmt wird,
   - Validieren (106) des Entwurfsmodells (2) für das technische System (1), wobei der jeweilige Wert für den wenigstens einen Parameter des technischen Systems (1) und der jeweilige Wert für die wenigstens eine Störgröße mit dem zulässigen Bereich des Entwurfsmodells (2) verglichen werden.

2. Verfahren (100) nach Anspruch 1, **dadurch gekennzeichnet,**

   **dass** das Verfahren (100) ferner den folgenden Schritt umfasst:

   - Übertragen der erfassten Ausgabe des technischen Systems (1) an eine externe Datenverarbeitungsvorrichtung (5),

   wobei das Ermitteln des Zustands und das Ermitteln der Störung und das Validieren des Entwurfsmodells (2) zusätzlich durch die externe Datenverarbeitungsvorrichtung (5) durchgeführt werden.

3. Verfahren (100) nach einem der vorhergehenden Ansprüche, **dadurch gekennzeichnet,**

   **dass** das technische System (1) ein Fahrzeug ist,
   wobei das Anwenden des Prüfsignals durch wenigstens einen Aktor (3) des Fahrzeugs durchgeführt wird,
   wobei das Erfassen der durch das Prüfsignal ausgelösten Ausgabe durch wenigstens einen Sensor (4) des Fahrzeugs durchgeführt wird.

4. Verfahren (100) nach einem der vorhergehenden Ansprüche, **dadurch gekennzeichnet, dass** das Verfahren (100) ferner den folgenden Schritt umfasst:

   - Durchführen wenigstens einer Maßnahme auf Basis eines Ergebnisses des Validierens (106), wobei die wenigstens eine Maßnahme das technische System (1) und/oder das Entwurfsmodell (2) beeinflusst.

5. Verfahren (100) nach Anspruch 4,
**dadurch gekennzeichnet,**
**dass** das Durchführen der wenigstens einen Maßnahme den folgenden Schritt umfasst:

- Anpassen wenigstens einer Funktion des technischen Systems (1), um durch das Anpassen eine Sicherheit des technischen Systems (1) zu erhöhen.

6. Verfahren (100) nach einem der Ansprüche 4 oder 5,
**dadurch gekennzeichnet,**
**dass** das Durchführen der wenigstens einen Maßnahme den folgenden Schritt umfasst:

- Anpassen des Entwurfsmodells (2) auf Basis des Ergebnisses des Validierens (106), um durch das Anpassen das Entwurfsmodell (2) für das technische System (1) zu individualisieren.

7. Verfahren (100) nach einem der vorhergehenden Ansprüche,
**dadurch gekennzeichnet,**

**dass** das Entwurfsmodell (2) als eine Referenz zur Überwachung des technischen Systems (1) verwendet und auf Basis einer Modellierung des technischen Systems (1) ermittelt wird,
wobei der Zustand zumindest einen physikalischen Energiespeicher des technischen Systems (1) und die Störung zumindest einen Umwelteinfluss auf das technische System (1) repräsentiert.

8. Computerprogramm (20), umfassend Befehle, die bei der Ausführung des Computerprogramms (20) durch einen Computer (10) diesen veranlassen, das Verfahren (100) nach einem der vorhergehenden Ansprüche auszuführen.

9. Vorrichtung (10) zur Datenverarbeitung, die eingerichtet ist, das Verfahren (100) nach einem der Ansprüche 1 bis 7 auszuführen.

10. Computerlesbares Speichermedium (15), umfassend Befehle, die bei der Ausführung durch einen Computer (10) diesen veranlassen, die Schritte des Verfahrens (100) nach einem der Ansprüche 1 bis 7 auszuführen.

# Fig. 1

# Fig. 2

# Fig. 3

Europäisches
Patentamt

European
Patent Office

Office européen
des brevets

# EUROPÄISCHER RECHERCHENBERICHT

Nummer der Anmeldung

EP 23 20 4535

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | Gleichweit Martin Kurt: "Fahrdynamische Validierung und Bewertung eines Rennfahrzeugmodells anhand realer Fahrzeugmessungen", , 1. Juni 2010 (2010-06-01), Seiten 1-120, XP093146363, Gefunden im Internet: URL:https://diglib.tugraz.at/download.php?id=576a89089af82 [gefunden am 2024-03-27] * das ganze Dokument * ----- | 1-10 | INV. G05B17/02 G05B19/418 ADD. B60W50/00 |
| X | EMIR KUTLUAY ET AL: "Validation of vehicle dynamics simulation models - a review", VEHICLE SYSTEM DYNAMICS: INTERNATIONAL JOURNAL OF VEHICLE MECHANICS AND MOBILITY, Bd. 52, Nr. 2, 7. Februar 2014 (2014-02-07), Seiten 186-200, XP055752504, GB ISSN: 0042-3114, DOI: 10.1080/00423114.2013.868500 * das ganze Dokument * ----- | 1-10 | |
| A | Schramm Dieter: "Modellbildung und Simulation der Dynamik von Kraftfahrzeugen", , 1. Januar 2011 (2011-01-01), XP055973892, Gefunden im Internet: URL:https://link.springer.com/book/10.1007/978-3-540-89315-8 * Abschnitte 9.3, 10, 11.2, 11.3 * ----- -/-- | 1-10 | |

RECHERCHIERTE SACHGEBIETE (IPC)

G05B
B60W

Der vorliegende Recherchenbericht wurde für alle Patentansprüche erstellt

| Recherchenort | Abschlußdatum der Recherche | Prüfer |
|---|---|---|
| Den Haag | 2. April 2024 | Kielhöfer, Patrick |

EPO FORM 1503 03.82 (P04C03)

Seite 1 von 2

Europäisches Patentamt

European Patent Office

Office européen des brevets

**EUROPÄISCHER RECHERCHENBERICHT**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | Lindermeir W W ET AL: "Regelungstechnik 1",<br><br>,<br>1. Juli 2019 (2019-07-01), Seiten 1-151, XP093146932,<br>Gefunden im Internet:<br>URL:http://www.wernerzimmermann.name/media/files/Regelungstechnik.pdf<br>[gefunden am 2024-04-02]<br>* Kapitel 2, 3 *<br>----- | 1-10 | |

**RECHERCHIERTE SACHGEBIETE (IPC)**

Der vorliegende Recherchenbericht wurde für alle Patentansprüche erstellt

| Recherchenort | Abschlußdatum der Recherche | Prüfer |
|---|---|---|
| Den Haag | 2. April 2024 | Kielhöfer, Patrick |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
.............................................................................
& : Mitglied der gleichen Patentfamilie, übereinstimmendes Dokument

EPO FORM 1503 03.82 (P04C03)